Europäisches Patentamt

(19) European Patent Office

Office européen des brevets

(11) Veröffentlichungsnummer: **0 017 901**
**B1**

(12) # EUROPÄISCHE PATENTSCHRIFT

(45) Veröffentlichungstag der Patentschrift:
31.10.84

(21) Anmeldenummer: 80101882.1

(22) Anmeldetag: 09.04.80

(51) Int. Cl.³: **G 01 R 17/06**

(54) **Schaltung zum elektrischen Messen mechanischer Grössen.**

(30) Priorität: 14.04.79 DE 2915319

(43) Veröffentlichungstag der Anmeldung:
**29.10.80 Patentblatt 80/22**

(45) Bekanntmachung des Hinweises auf die Patenterteilung:
**31.10.84 Patentblatt 84/44**

(84) Benannte Vertragsstaaten:
**FR GB NL**

(56) Entgegenhaltungen:
**DD - A - 118 727**
**DE - A - 2 518 422**
**DE - A - 2 900 382**
**DE - B - 1 573 826**
**DE - B - 2 164 315**
**FR - A - 2 337 344**
**GB - A - 1 414 144**
**US - A - 3 678 373**
**US - A - 3 956 927**

**JOURNAL OF PHYSICS E: Scientific Instruments, 1975,
Vol. 8 Seiten 1049-1052**
**CONTROL AND INSTRUMENTATION, Dezember 1976,
Seiten 36, 37**
**Royal Aircraft Establishment, Technical Report 77155,
Oct. 1977, Controller HMSO, London**

(73) Patentinhaber: **Deutsche Forschungs- und
Versuchsanstalt für Luft- und Raumfahrt e.V., Linder
Höhe, D-5000 Köln 90 (DE)**

(72) Erfinder: **Gatzek, Wolfgang, Dipl.Ing., Görlitzer
Strasse 31, D-3406 Bovenden 1 (DE)**

(74) Vertreter: **Rehberg, Elmar, Dipl.-Ing. et al,
Patentanwälte, Dipl.-Ing. R. Bibrach Dipl.-Ing. E.
Rehberg Postfach 7 38 Pütterweg 6, D-3400 Göttingen
(DE)**

**Beschreibung**

Die Erfindung bezieht sich auf eine Schaltung zum elektrischen Messen mechanischer Größen mit den im Oberbegriff des Anspruches 1 angegebenen Merkmalen.

Beim elektrischen Messen mechanischer Größen unter Temperaturänderung während des Meßvorganges stellen sich insbesondere zwei Probleme ein, nämlich Nullpunktsänderungen des Systems infolge Temperaturänderungen und Empfindlichkeitsänderungen des Systems infolge Temperaturänderungen. Um diesen beiden das Meßergebnis verfälschenden Einflüssen entgegenzuwirken, ist im Stand der Technik einerseits die aktive und andererseits die passive Kompensation bekannt. Die vorliegende Erfindung baut auf der aktiven Kompensation auf.

Ganz allgemein ist es bekannt, zur Messung mechanischer Größen, z. B. Drücke, Verschiebungen, Beschleunigungen usw., Halbleitermeßaufnehmer einzusetzen. Sie nutzen den piezoresistiven Effekt von Silizium aus, das dielektrisch isoliert auf eine Siliziummembran in Form der Wheatstone'schen Brückenschaltung aufgebracht ist. Die mechanische Belastung der Halbleiterelemente führt zu elektrischen Spannungsänderungen, die in der Meßbrückenschaltung die folgende Form hat:

$$U_M = \varepsilon B\, U_S; \quad \varepsilon \sim p$$

$U_M$ bedeutet die fehlerfreie Ausgangs-Meßspannung, $\varepsilon$ die Dehnung, $U_S$ die an die Brücke angelegte Speisespannung, B den Brückenfaktor und p den Druck.

Diese Gleichung genügt der idealen Wheatstone-Brücke, in der alle vier der mechanischen Belastung unterworfenen Widerstandszweige dem Betrag nach und im Temperturkoeffizienten gleich sind. Im Gegensatz hierzu verhält sich aber der reale Druckaufnehmer. Trotz hoher Fertigungsgenauigkeit reagiert er auf Temperaturschwankungen sehr empfindlich. Sein Brückenfaktor nimmt z. B. mit steigender Temperatur ab. Dies hat zur Folge, daß die Ausgangs-Meßspannung trotz konstanten Drucks sinkt und so einen sich verkleinernden Druck vortäuscht. Weiterhin ist ein temperaturabhängiger Fehlabgleich bei der realen Brücke vorhanden, der sich als additive Größe erweist. Die Gleichung des realen Meßaufnehmers lautet daher

$$U_M' = \varepsilon B(T)\, U_S \pm U_{OS}\,(T)$$

$U_M'$ ist die fehlerbehaftete Meßspannung; $U_{OS}$ ist die Fehlspannung bzw. Offsetspannung. Um die Temperatureinflüsse auf Empfindlichkeit und Fehlspannung auszuschalten, bedient man sich sowohl der passiven als auch der aktiven Kompensation.

Bei der aktiven Kompensation — soweit sie für die Erfindung wesentlich ist — werden ein Meßwertaufnehmer in Form einer Wheatstone-Brücke, zwei Verstärker, ein Subtrahierglied und ein Fühlerglied zusammengeschaltet. Das Fühlerglied besteht aus einem sehr kleinen Korrekturwiderstand, der in der Zuleitung der Brückenspeisung liegt. Die an ihm abfallende Spannung (Korrekturspannung) wird durch den Brückenstrom erzeugt:

$$U_{KO} = I_B R_{KO} = \frac{R_{KO}}{R_B + R_{KO}}\, U_S \approx \frac{R_{KO}}{R_B} \cdot U_S.$$

Dabei bedeuten: $U_{KO}$ die Korrekturspannung, $I_B$ den Brückenstrom, $R_{KO}$ den Korrekturwiderstand und $R_B$ den Gesamtwiderstand der Wheatstone-Brücke.

Ändert sich der Brückenstrom $I_B$ aufgrund von Temperatureinflüssen auf die Brücke, indem der Brückenwiderstand steigt bzw. fällt, so wird die Korrekturspannung kleiner bzw. größer:

$$\Delta U_{KO} \sim U_{KO}(T_0) \cdot \alpha_B' \cdot \Delta T = K' \cdot \alpha_B' \cdot \Delta T$$

$\alpha_B'$ ist der Temperaturkoeffizient des Brückenfaktors. Zur Kompensation der fehlerbehafteten Meßspannung wird die Korrekturspannung dem Temperaturgang der fehlerbehafteten Meßspannung entsprechend verstärkt und in der Zwischenstufe des Verstärkers mit der gleich großen und entgegengesetzten fehlerbehafteten Meßspannung addiert:

$$a\, U_{KO} - b\, U_{OS} = 0$$

a, b sind Verstärkungsfaktoren.

Die nun fehlerfreie Ausgangs-Meßspannung wird in einer Folgestufe auf ihren Endwert verstärkt.

Zur Kompensation der Empfindlichkeitsschwankung regelt die Korrekturspannung gleichzeitig einen variablen Verstärkungsfaktor in jener Folgestufe, der dem Brückenfaktorschwund bei Temperaturanstieg entgegenwirkt:

$$U_M = \varepsilon U_S B(T) A(T) = \varepsilon U_S K$$

A(T) ist der variable, temperaturabhängige Verstärkungsfaktor, K ist eine Konstante.

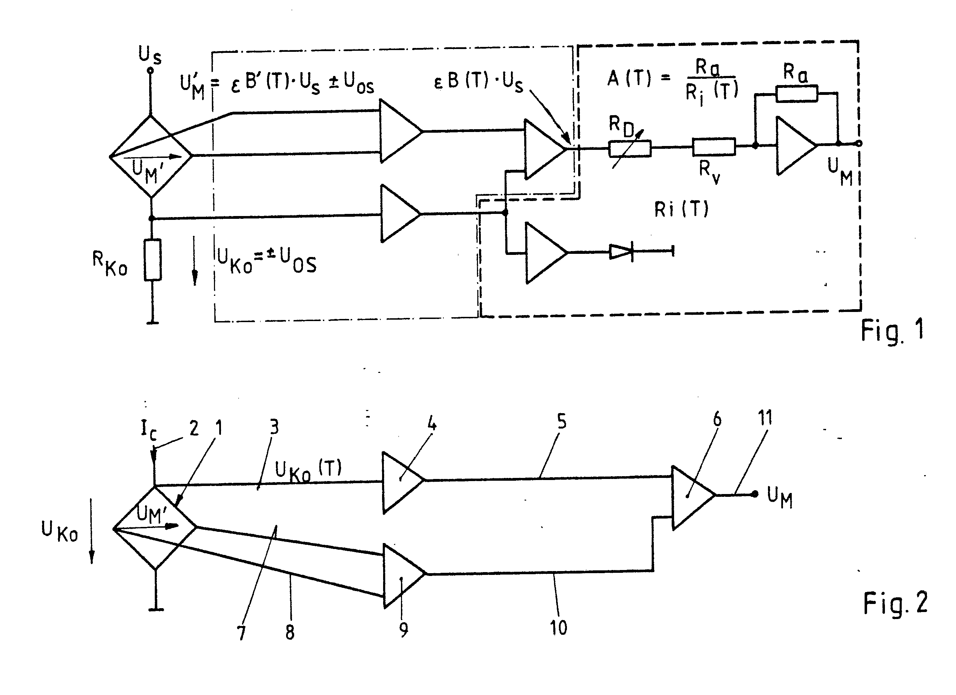

Eine Meßschaltung mit aktiver Kompensation, von der die Erfindung ausgeht, ist in Fig. 1 dargestellt, wobei der der Wheatstone-Brücke und dem Fühlerglied direkt nachgeschaltete Teil der Meßschaltung für die Kompensation der fehlerbehafteten Meßspannung und der sodann folgende Teil unter Verwendung eines Optokopplers für die Kompensation der Empfindlichkeitsänderung infolge Temperaturänderung vorgesehen ist, (vgl. auch Royal Aircraft Establishment, Technical Report 77155, Okt. 1977, . . . A method to improve the temperature stability of semiconductor strain gauge pressure transducers by Welsh and Pyne, Copyright: Controller HMSO, London).

Neben der aktiven Kompensation ist auch die passive Kompensation bekannt.

Die Anfänge der passiven Kompensation zeigt die US-A-3 956 927. Die Wheatstone-Brücke wird in zwei Zweige zerlegt, von denen der eine zur Messung z. B. der mechanischen Dehnung und der andere zur Kompensation dient. Hierzu, wie auch in der DE-B-1 573 826, wird die Brücke mit einem Konstantstrom gespeist. Die daraus resultierende Spannung steigt mit dem sich z. B. bei steigender Temperatur vergrößernden Widerstand an und verringert dadurch die Abnahme der Empfindlichkeit. Dadurch wird die Konstanthaltung des Verhältnisses von Ausgangs- zur Eingangsspannung in einem weiten Temperaturbereich erreicht, also eine grobe passive Kompensation. Die Schwierigkeit dürfte allerdings darin bestehen, die Halbzweige aufeinander anzupassen und die temperaturbedingte Verringerung der Empfindlichkeit auf die Vergrößerung der Widerstände abzustimmen. Hierzu gibt die US-A-3 956 927 keine Lösung an.

Aus diesem Grund zielt eine bekannte Verbesserung dieser passiven Kompensation darauf ab, alle vier Widerstände der Brücke mit temperaturunabhängigen Widerständen aufeinander abzustimmen. Dieses Prinzip beruht auf der Tatsache, daß ein temperaturunabhängiger Widerstand mit einem temperaturabhängigen Widerstand in Reihe oder parallel geschaltet einen Widerstand ergibt, dessen Gesamttemperaturkoeffizient kleiner als der des temperaturabhängigen ist.

Serienschaltung:

$$\alpha' = \frac{R_T}{R_T + R_S} \, \alpha; \, \alpha' \leq \alpha$$

$\alpha'$ bedeutet den Gesamttemperaturkoeffizienten, $\alpha$ den Temperaturkoeffizienten des temperaturabhängigen Widerstandes $R_T$ und $R_S$ den Serienwiderstand.

Parallelschaltung:

$$\alpha' = \frac{R_P}{R_T + R_P} \, \alpha; \, \alpha' \leq \alpha$$

$R_P$ bedeutet den Parallelwiderstand.

Netzwerk aus Serien- und Parallelschaltung zur Beibehaltung des alten Widerstandsbeiwertes:

$$\alpha' = \frac{R_T R_P}{(R_T + R_S)(R_T + R_P)} \, \alpha; \, \alpha' \leq \alpha$$

Schaltet man ein solches passives Netzwerk aus Widerständen ohne Verstärker in den Zweig der Brücke mit dem größeren Temperaturkoeffizienten, so kann man mit der Wahl geeigneter Widerstandswerte die Differenz zweier Produkte zu Null machen; d. h. die Fehlspannung $U_{OS}$ wird temperaturunabhängig.

(Abgleichbedingung:
$R_{T1} \cdot R_{T4} - R_{T2} \cdot R_{T3} = 0$)
Mit $R_{Ti} = R_{Ti}(T_0) \cdot (1 + \alpha_{Ti} \cdot \Delta T)$

Die passive Kompensation der Empfindlichkeitsabnahme sieht einen temperaturunabhängigen Vorwiderstand in den Zuleitungen vor. Bei Temperaturzunahme steigt nun der Brückengesamtwiderstand und somit auch die an ihm liegende Spannung U auf Kosten der sich verringernden Spannung am Vorwiderstand:

$$U(T) = \frac{R_T}{2R_Z + R_T} U_S$$

$R_Z$ bedeutet den Vorwiderstand in der Zuleitung.

Dadurch erhält die Brücke eine steigende Speisespannung, die der Verringerung des Brückenfaktors entgegenwirkt; denn es gilt bei gleicher Meßspannung für zwei Temperaturen $T_1$ und $T_2$, daß die Produkte $U(T) \cdot B(T)$ konstant sein müssen:

$$U(T_1) \, B(T_1) = B(T_2) \, U(T_2).$$

Die passive Kompensation besitzt folgende Nachteile:

Das Ausgangssignal des Meßwertaufnehmers ist klein und muß daher von einem Verstärker aufgebessert werden. Der immer vorhandene Fehlabgleich ist oftmals zu groß, um von einem üblichen Verstärker für eine konstante Temperatur kompensiert zu werden. Man behilft sich daher meist mit einem dem Aufnehmer parallel geschalteten Potentiometer und mit einem Reihenwiderstand zwischen Brücke und Schleifer. Trotz hoher Widerstandswerte kann eine nachteilige Wirkung auf die Brückenwiderstände z. B. Verminderung der Empfindlichkeit, nicht verhindert werden.

Die durch die Beschaltung mit einem Potentiometer hervorgerufene Nachteile bei dieser passiven Kompensation werden durch die in der GB-A-1 414 144 erläuterte Schaltung vermieden. Hier sorgt ein Referenzverstärker für die Entkoppelung des Potentiometers und der Widerstandsbrücke.

Fig. 2 dieser GB-A-1 414 144 stellt eine spannungsgespeiste Brückenschaltung dar, in der der Referenzverstärker keine temperaturbedingte Brückenwiderstandsänderungen erkennen kann, wie es hierzu im Gegensatz die stromgespeiste Widerstandsbrücke der Anmeldung kann.

Der Referenzverstärker eliminiert Schwankungen der Spannungsquelle, nicht aber Schwankungen der Brückenschaltung. Die Schaltung der Fig. 2 kann deshalb auch nur für eine bestimmte Temperatur eingestellt werden, ist also für variierende Temperaturen, wie sie z. B. im Windkanal auftreten, nicht geeignet.

Eine weitere Möglichkeit, die stochastischen und temperaturbedingten Schwankungen der Fehlspannung bei der passiven Kompensation auszuschalten, besteht darin, zwischen Aufnehmer und Verstärker ein Hochpaßfilter zu schalten. Schnelle Druckvorgänge werden dann weder in Amplitude noch Phase beeinflußt; allerdings werden langsame Druckänderungen verfälscht und statische Drücke unterdrückt.

Die für die Korrektur der Empfindlichkeitsschwankung in Frage kommenden Reihenwiderstände dürfen bei den üblichen Spannungsquellen nicht zu groß und die Parallelwiderstände nicht zu klein gewählt werden. Der eigentliche Nachteil der passiven Kompensation liegt in der gegenseitigen Beeinflussung von Fehlspannungs- und Empfindlichkeitskorrektur. Die Einstellung dieser beiden Größen ist daher immer eine Kompromißlösung.

Bei Alterung der Halbleiteraufnehmer ist ein erneuter Abgleich nicht mehr möglich.

Die eingangs behandelte aktive Kompensation, von der die Erfindung ausgeht, besitzt folgende Nachteile: — wie auch bei der passiven Kompensation — müssen zwei Größen, nämlich Nullpunktsänderungen und Empfindlichkeitsänderungen korrigiert werden. Die Schwierigkeit besteht jedoch darin, zwei Korrekturglieder zur Korrektur der beiden Größen zu finden. Dies ist bei den bekannten aktiven Kompensationsverfahren bisher nicht gelungen, obwohl zwei Korrekturglieder eingesetzt werden. Beide Korrekturglieder sind von ein und demselben Fühler abhängig. Dabei ist die Korrektur der Nullpunktsänderungen zwar hinreichend genau, da sich die Verringerung des Stromes in der Brücke bei Temperaturanstiegen fast linear zur Temperatur verhält. Die Korrektur der Empfindlichkeitsänderungen ist jedoch nicht hinreichend genau, da sowohl die zu korrigierende Größe wie auch das Korrekturglied in unterschiedlicher Weise je einen nichtlinearen Verlauf aufweisen. Ferner ist das zweite Korrekturglied selbst temperaturinstabil.

Ein Beispiel soll dies verdeutlichen: Der Temperaturkoeffizient des zweiten Korrekturgliedes beträgt 1% pro Grad Celsius. Dadurch entsteht neben dem Fehlabgleich durch Nichtlinearität ein zusätzlicher Fehler von 0,1 bis 0,2% pro Grad Celsius, da üblicherweise 10 bis 20% Empfindlichkeitsminderungen in einem bestimmten Temperaturbereich ausgeglichen werden müssen.

Der Gesamtfehler, der sich aus Offset- und Empfindlichkeitsfehler zusammensetzt, liegt in der Größenordnung der Fehler der passiven Kompensation, also etwa bei ±2,5% in einem Temperaturbereich von 50° C.

Der Erfindung liegt die Aufgabe zugrunde, eine Meßschaltung der eingangs beschriebenen Art derart weiterzubilden, daß sich mit ihr genauer messen läßt, wobei einerseits Nullpunktsänderungen infolge Temperaturänderungen und andererseits Empfindlichkeitsänderungen infolge Temperaturänderungen minimiert werden sollen.

Erfindungsgemäß wird dies dadurch erreicht, daß die Wheatstone-Brücke mit ihrem Gesamtwiderstand zugleich den Korrekturwiderstand bildet, daß zwecks aktiver Kompensation der Empfindlichkeitsschwankungen der Wheatstone-Brücke das Produkt aus dem Gesamtwiderstand und dem Brückenfaktor der Wheatstone-Brücke hinsichtlich der Temperatur konstant ist und daß zur Versorgung der Wheatstone-Brücke eine Konstantstromquelle vorgesehen ist.

Wie ersichtlich, benötigt man für die erforderliche Genauigkeit und Stabilität während des Meßvorganges zwei geeignete voneinander unabhängige Korrekturglieder. Das erste Korrekturglied, um Fehlspannungsdriften kompensieren zu können, besteht aus der Wheatstone-Brücke selbst, ohne durch externe Fühlerwiderstände die Aufnehmereigenschaften zu verändern, die letztlich wieder korrigiert werden müßten. Hierzu wird der Temperaturkoeffizient der Fehlspannung von dem Temperaturkoeffizienten der Brücke abgezogen:

$$F = a\,TCU_{OS} - b\,TCR_B$$

F ist der Fehler, $TCU_{OS}$ ist der Temperaturkoeffizient der Fehlspannung, $TCR_B$ ist der Temperaturkoeffizient des Brückenwiderstandes.

Das zweite Korrekturglied, das zur Verringerung der Empfindlichkeitsschwankungen gegenüber Temperatureinflüssen dient, stellt die Speisung der Wheatstone-Brücke mit Konstantstrom sowie die Konstanthaltung des Produktes von Gesamtwiderstand und Brückenfaktor der Wheatstone-Brücke

$$R_B(T)\ B(T) = \text{konstant}$$

dar. Ist der Innenwiderstand der Konstantstromquelle genügend hoch gegenüber den Änderungen des Gesamtwiderstandes der Brücke, so bleibt der Strom durch die Brücke konstant. Dies hat zur Folge, daß die Brückenspannung der durch Temperaturänderungen hervorgerufenen Widerstandsänderung folgt und somit die Empfindlichkeit exakt temperaturunabhängig bleibt. Die fehlerbehaftete Meßspannung an der Brükkendiagonalen lautet:

$$U_M' = \mathit{l}_C \cdot R_B(T) \cdot B(T) \pm U_{OS}(T)$$

$I_C$ bedeutet den Konstantstrom.

Wie man sieht, hängt der Fehler der fehlerbehafteten Meßspannung $U_M'$ nur noch von der Offsetspannungsdrift $U_{OS}(T)$ ab. Die Verwendung einer Konstantstromquelle, um ganz allgemein einen Spannungsabfall an langen Leitungen zu vermeiden und um eine Induktion von Spannung durch elektrische Felder zu umgehen, ist an sich bekannt. Nach der Erfindung jedoch wird die Speisung der Wheatstone-Brücke mit Konstantstrom zu dem Zwecke durchgeführt, um einerseits in der den Verlauf der fehlerbehafteten Meßspannung beschreibenden Formel ein Produkt aus dem Gesamtwiderstand und dem Brückenfaktor zu erhalten, welche sich konstant halten läßt, und um andererseits den Brückenstrom selbst als dritten Faktor in der Formel konstant zu halten (vgl. die vorangehende Formel).

Der Vorteil der erfindungsgemäßen Meßschaltung besteht darin, daß sich der Gesamtfehler um den Fehler verringert, der aus ungenügender Kompensation der Empfindlichkeitsschwankung bei anderen Verfahren entsteht. Mit anderen Worten, die Genauigkeit hängt nur noch von der Güte der Offsetspannungsdriftkompensation ab. Bei den untersuchten unkompensierten Aufnehmern konnten die Offsetspannungsdriften um Faktoren zwischen 50 bis 200 verringert werden. Der restliche Fehler verläuft in erster Näherung parabolisch im betrachteten Temperaturbereich

$$F = a\,(T-T_1) \cdot (T-T_2),$$

da der Fehler nur bei zwei bestimmten Temperaturen $T_1$ und $T_2$ exakt zu Null wird.

Kennt man den Temperaturbereich, in dem der Meßwertaufnehmer arbeiten soll, so kompensiert man denselben in diesem Bereich — er ist im allgemeinen kleiner als der handelsüblich angebotene Bereich. Durch diese Anpassung bzw. Verkleinerung nimmt der Fehler quadratisch ab.

Ferner besteht der Vorteil, die erfindungsgemäße Wheatstone-Brücke universeller als bisher einsetzen und den speziellen Gegebenheiten, wie z. B. den unterschiedlichen Druckniveaus und Temperaturbereichen, z. B. in verschiedenen Windkanälen, besser anpassen zu können.

Im Gegensatz zum Stand der Technik ist die erfindungsgemäße Meßschaltung auch sehr schnell, d. h. sie kann auch bei sehr schnell ablaufenden Vorgängen, z. B. bei der Druckmessung bei einem Berstversuch, eingesetzt werden.

Die Konstantstromquelle kann zur Erzielung des Brückenabgleichs, insbesondere zur Verschiebung des Arbeitstemperaturbereichs, einstellbar ausgebildet sein.

Der Verstärker für die Korrekturspannung der den Korrekturwiderstand bildenden Wheatstone-Brücke besitzt einen einstellbaren Verstärkungsfaktor zur Minimierung des Fehlers im Arbeitstemperaturbereich. Damit wird der Arbeitstemperaturbereich festgelegt. Es versteht sich, daß mit kleiner werdendem Arbeitstemperaturbereich die Messung genauer wird. Weiterhin kann auch der Verstärker für die von der Wheatstone-Brücke abgegebene fehlerbehaftete Meßspannung einen einstellbaren Verstärkungsfaktor zum Einstellen des Meßbereichs der Wheatstone-Brücke besitzen. Durch Verkleinerung des Meßbereichs ergibt sich die Möglichkeit einer Anpassung, z. B. eine Vergrößerung, des Ausgangssignals und damit eine Vergrößerung der Genauigkeit der Messung.

In der Meßtechnik ergeben sich bei der Anwendung der bisherigen Schaltungen zwei unangenehme Effekte. Längere Zuleitungen vom Meßwertaufnehmer zum Verstärker bedeuten nicht zu vernachlässigende Vorwiderstände, die die Kompensation verschlechtern und die Empfindlichkeit herabsetzen. Dagegen ist die Güte der jetzigen Schaltung von der Zuleitungslänge unabhängig.

Als letzterer Vorteil sei die Linearität der fehlerfreien Ausgangs-Meßspannung in Abhängigkeit des Druckes erwähnt. Sie ist um den Faktor 2 besser.

Bei der Spannungsspeisung nach dem Stand der Technik bei als konstant angenommener Temperatur ergibt sich für die Ausgangs-Meßspannung:

$$\frac{U_M}{U_S} = \frac{1}{4} \cdot \frac{\varDelta R}{R} - \frac{1}{8}\left(\frac{\varDelta R}{R}\right)^2$$

Bei Stromspeisung nach der Erfindung:

$$\frac{U_M}{I_C R} = \frac{1}{4} \cdot \frac{\varDelta R}{R} - \frac{1}{16}\left(\frac{\varDelta R}{R}\right)^2$$

$\varDelta R/R$ bedeutet die relative Widerstandsänderung eines Brückenzweiges.

In Fig. 2 ist die erfindungsgemäße Meßschaltung prinzipiell verdeutlicht:

Als Meßwertaufnehmer dient die Wheatstone-Brücke 1, die von der Konstantstromquelle 2 gespeist wird. Da die Wheatstone-Brücke 1 selbst als Korrekturwiderstand benutzt wird, wird die Korrekturspannung über die Leitung 3 dem Verstärker 4 zugeführt und dort verstärkt. Über die Leitung 5 gelangt die verstärkte Korrekturspannung zu dem Subtrahierglied 6. Parallel dazu wird die fehlerbehaftete Meßspannung $U_M'$ über die Leitungen 7 und 8 dem zweiten Verstärker 9 zugeführt und gelangt über die Leitung 10 ebenfalls zu dem Subtrahierglied 6. Am Ausgang des Subtrahiergliedes 6 wird die fehlerfreie Ausgangs-Meßspannung $U_M$ über die Leitung 11 abgegeben.

**Patentansprüche**

1. Schaltung zum elektrischen Messen mechanischer Größen, mit einer Wheatstone-Brücke (1), bei der die von dieser Wheatstone-Brücke (1) abgegebene fehlerbehaftete Meßspannung ($U_M'$) durch aktive Kompensation mittels eines Korrekturwiderstandes zur Erzeugung einer Korrekturspannung ($U_{KO}$), je eines Verstärkers (4, 9) für die Korrekturspannung ($U_{KO}$) einerseits und die fehlerbehaftete Meßspannung ($U_M'$) andererseits sowie eines nachgeschalteten Subtrahiergliedes (6) für die beiden verstärkten Spannungen in eine fehlerfreie Ausgangs-Meßspannung ($U_M$) umgeformt wird, dadurch gekennzeichnet, daß die Wheatstone-Brücke (1) mit ihrem Gesamtwiderstand zugleich den Korrekturwiderstand bildet, daß zwecks aktiver Kompensation der Empfindlichkeitsschwankungen der Wheatstone-Brücke (1) das Produkt aus dem Gesamtwiderstand und dem Brückenfaktor der Wheatstone-Brücke (1) hinsichtlich der Temperatur konstant ist und daß zur Versorgung der Wheatstone-Brücke (1) eine Konstantstromquelle (2) vorgesehen ist.

2. Schaltung nach Anspruch 1, dadurch gekennzeichnet, daß die Konstantstromquelle (2) zur Erzielung des Brückenabgleichs, insbesondere zur Verschiebung des Arbeitstemperaturbereichs, einstellbar ausgebildet ist.

3. Schaltung nach Anspruch 1 oder 2, dadurch gekennzeichnet, daß der Verstärker (4) für die Korrekturspannung ($U_{KO}$) der den Korrekturwiderstand bildenden Wheatstone-Brücke (1) einen einstellbaren Verstärkungsfaktor zur Minimierung des Fehlers im Arbeitstemperaturbereich besitzt.

4. Schaltung nach Anspruch 1, dadurch gekennzeichnet, daß der Verstärker (9) für die von der Wheatstone-Brücke (1) abgegebene fehlerbehaftete Meßspannung ($U_M'$) einen einstellbaren Verstärkungsfaktor zur Einstellung des Meßbereichs der Wheatstone-Brücke (1) besitzt.

**Claims**

1. A circuit for the electric measurement of mechanical variables, comprising a Wheatstone bridge (1) and in which circuit the fault-encumbered measured voltage ($U_M'$) supplied by this Wheatstone bridge (1) is converted, by active compensation by means of a correction resistance for generating a correction voltage ($U_{KO}$) of one amplifier (4, 9) each for the correction voltage ($U_{KO}$) on the one hand and the fault-encumbered measured voltage ($U_M'$) on the other hand, and of a subsequent subtracting element (6) for the two amplified voltages, into a fault-free output measured voltage ($U_M$), characterised in that the Wheatstone bridge (1) simultaneously forms the correction resistance by means of its total resistance, that, for the purpose of active compensation of the sensitivity fluctuation of the Wheatstone bridge (1), the product of the total resistance and the bridge factor of the Wheatstone bridge (1) is constant with respect to temperature and that a constant current source (2) is provided for supplying the Wheatstone bridge (1).

2. A circuit according to Claim 1, characterised in that the constant current source (2) is constructed to be adjustable in order to achieve bridge calibration and especially in order to displace the range of working temperature.

3. A circuit according to Claim 1 or 2, characterised in that the amplifier (4) for the correction voltage ($U_{KO}$) of the Wheatstone bridge (1) forming the correction resistance has an adjustable gain factor for minimising the error in the working-temperature range.

4. A circuit according to Claim 1, characterised in that the amplifier (9) for the error-encumbered measured voltage ($M_M'$) supplied by the Wheatstone bridge (1) has an adjustable gain factor for adjusting the measuring range of the Wheatstone bridge (1).

**Revendications**

1. Circuit pour la mesure électrique de grandeurs mécaniques, comportant un pont de Wheatstone (1), dans lequel la tension de mesure faussée ($U_M'$), délivrée par ce pont de Wheatstone (1), est transformée en une tension de mesure ($U_M$) sans erreur par compensation active au moyen d'une résistance de correction produisant une tension de correction ($U_{KO}$), d'un amplificateur (4, 9) d'une part pour la tension de correction ($U_{KO}$) et d'autre part pour la tension de mesure faussée ($U_M'$), ainsi que d'un élément soustracteur (6), monté à la suite, pour les deux tensions amplifiées, caractérisé en ce que le pont de Wheatstone (1) forme en même temps, avec sa résistance totale, la résistance de correction; que, pour la compensation active des variations de sensibilité du pont de Wheatstone (1), le produit de la résistance totale par le facteur de pont du pont de Wheatstone (1) est constant en ce qui concerne la température et qu'on prévoit, pour l'alimentation du pont de Wheatstone (1) une source de courant constant (2).

2. Circuit suivant la revendication 1, caractérisé en ce que la source (2) de courant constant destinée à obtenir l'équilibrage du pont, en particulier pour le déplacement de la gamme de température de travail, est réglable.

3. Circuit suivant une quelconque des revendications 1 et 2, caractérisé en ce que l'amplificateur (4) pour la tension de correction ($U_{KO}$) du pont de Wheatstone (1), formant la résistance de correction, possède un facteur d'amplification rélable destiné à réduire le plus possible l'erreur présente dans la gamme de température de travail.

4. Circuit suivant la revendication 1, caractérisé en ce que l'amplificateur (9) pour la tension de mesure faussée ($U_M'$), délivrée par le pont de Wheatstone (1), possède un facteur réglable d'amplification destiné au réglage de la gamme de mesure du pont de Wheatstone (1).

Fig. 1

$U'_M = \varepsilon B'(T) \cdot U_S \pm U_{OS}$

$\varepsilon B(T) \cdot U_S$

$A(T) = \dfrac{R_a}{R_i(T)}$

$R_a$

$R_D$

$R_v$

$U_M$

$R_i(T)$

$U_{Ko} = \pm U_{OS}$

$R_{Ko}$

$U_S$

$U_{M'}$

Fig. 2

$I_c$

$U_{Ko}(T)$

$U_M$

$U_{Ko}$

$U_{M'}$

0 017 901